# FASCICULE DE BREVET EUROPEEN

(11) **EP 3 913 680 B1**
(45) Date de publication et mention de la délivrance du brevet: **23.07.2025**
(21) Numéro de dépôt: 21183598.8
(22) Date de dépôt: 13.05.2016
(51) Int. Cl.: H10H 29/01, H10H 29/03, H10H 29/80, H10H 29/14, H10H 20/01

(54) **PROCÉDÉ DE FABRICATION D'UN DISPOSITIF OPTOÉLECTRONIQUE COMPORTANT UNE PLURALITÉ DE DIODES AU NITRURE DE GALLIUM**
VERFAHREN ZUR HERSTELLUNG EINER OPTOELEKTRONISCHEN VORRICHTUNG, DIE EINE VIELZAHL VON DIODEN AUS GALLIUMNITRID UMFASST
METHOD FOR MANUFACTURING AN OPTOELECTRONIC DEVICE COMPRISING A PLURALITY OF GALLIUM NITRIDE DIODES

(43) Date de publication de la demande: 24.11.2021
(62) Demande divisionnaire de: 16730449.2
(73) Titulaire: Commissariat à l'Energie Atomique et aux Energies Alternatives, 75015 Paris (FR); THALES, 92400 Courbevoie (FR)
(72) Inventeur: TEMPLIER, François, 38054 GRENOBLE CEDEX 9 (FR); BENAISSA, Lamine, 91300 MASSY (FR); RABAROT, Marc, 38120 SAINT-EGREVE (FR)
(74) Mandataire: Cabinet Beaumont

(56) Documents cités:
- US-A1- 2012 080 695
- US-A1- 2015 014 716
- US-A1- 2015 155 331
- US-A1- 2015 333 047

## Description

### Domaine

La présente demande concerne le domaine des dispositifs optoélectroniques. Elle concerne plus particulièrement un procédé de fabrication d'un dispositif optoélectronique comportant une pluralité de diodes au nitrure de gallium, et un circuit électronique de contrôle de ces diodes.

### Exposé de l'art antérieur

On a déjà proposé un dispositif d'affichage émissif comportant un ensemble de diodes électroluminescentes (LEDs) au nitrure de gallium, et un circuit de contrôle permettant de commander individuellement les LEDs pour afficher des images.

Pour réaliser un tel dispositif, on peut prévoir de fabriquer séparément le circuit de contrôle et l'ensemble de LEDs, puis de les connecter l'un à l'autre pour obtenir le dispositif d'affichage. Le circuit de contrôle peut être intégré dans et sur un substrat semiconducteur, par exemple un substrat de silicium. A titre d'exemple, le circuit de contrôle est réalisé en technologie CMOS. Du côté d'une de ses faces, le circuit de contrôle peut comprendre une pluralité de plots métalliques, chaque plot étant destiné à être connecté à une électrode d'une LED de l'ensemble de LEDs, pour pouvoir commander les LEDs individuellement. L'ensemble de LEDs est par exemple réalisé de façon monolithique sur un substrat de support, puis rapporté sur le circuit de contrôle de façon que chaque LED ait une électrode (anode ou cathode) connectée à l'un des plots métalliques du circuit de contrôle.

Un inconvénient de cette méthode de fabrication réside dans la nécessité d'aligner précisément le circuit de contrôle et l'ensemble de LEDs lors de l'étape d'assemblage de ces deux éléments, de façon que chaque LED vienne bien se positionner sur le plot métallique qui lui correspond dans le circuit de contrôle. Cet alignement est notamment difficile à réaliser lorsque le pas des pixels diminue, et constitue un frein à l'augmentation de la résolution et/ou de la densité d'intégration des pixels.

Une autre approche pour réaliser un dispositif optoélectronique comportant un ensemble de LEDs au nitrure de gallium et un circuit de contrôle de ces LEDs consiste à réaliser l'ensemble de LEDs de façon monolithique sur un substrat de support, puis à déposer des transistors de type TFT (de l'anglais "Thin Film Transistor" - transistor en couches minces) sur l'ensemble de LEDs pour former le circuit de contrôle.

Un inconvénient de cette approche réside dans les performances relativement faibles et dans les dispersions de fabrication relativement élevées des transistors TFT du circuit de contrôle. De plus, les transistors TFT sont relativement encombrants, ce qui, là encore, limite l'augmentation de la résolution et/ou de la densité d'intégration des pixels.

### Résumé

Ainsi, un mode de réalisation prévoit un procédé de fabrication d'un dispositif optoélectronique, comportant les étapes successives suivantes : a) rapporter, sur une face d'un circuit intégré de contrôle préalablement formé dans et sur un substrat semiconducteur et comportant une pluralité de plots métalliques de connexion, un empilement actif de diode comportant au moins des première et deuxième couches semiconductrices dopées de types de conductivité opposés, de façon que la deuxième couche de l'empilement soit électriquement connectée aux plots métalliques du circuit de contrôle ; et b) former dans l'empilement actif des tranchées délimitant une pluralité de diodes connectées à des plots métalliques distincts du circuit de contrôle, dans lequel, à l'étape a), les couches métalliques suivantes font interface entre le circuit intégré de contrôle et l'empilement actif: une première couche métallique s'étendant sur sensiblement toute la surface du circuit de contrôle côté plots métalliques; et une deuxième couche métallique s'étendant sur sensiblement toute la surface de la deuxième couche semiconductrice opposée à la première couche semiconductrice, dans lequel, à l'étape a), l'empilement actif de diode est fixé sur le circuit de contrôle par collage moléculaire de la première couche métallique sur la deuxième couche métallique, dans lequel la première couche métallique comprend une couche supérieure en un métal de même nature qu'une couche supérieure de la deuxième couche métallique , la fixation de l'empilement actif de diode sur le circuit de contrôle étant obtenue par mise en contact direct desdites couches supérieures l'une avec l'autre.

Selon un mode de réalisation, au moins l'une des première et deuxième couches métalliques comprend une couche réfléchissante en argent.

Selon un mode de réalisation, au moins l'une des première et deuxième couches métalliques comprend une couche barrière en TaN, TiN, WN, TiW, ou en une combinaison d'un ou plusieurs de ces matériaux.

Selon un mode de réalisation, les première et deuxième couches métalliques sont en Ti, Ni, Pt, Sn, Au, Ag, Al, Pd, W, Pb, Cu, AuSn, TiSn, NiSn ou en un alliage de tout ou partie de ces matériaux.

Selon un mode de réalisation, les tranchées formées à l'étape b) s'étendent sur toute la hauteur de l'empilement actif et traversent les première et deuxième couches métalliques.

Selon un mode de réalisation, lors de la mise en oeuvre de l'étape a), l'empilement actif est supporté par un substrat de support situé du côté de la première couche semiconductrice opposé à la deuxième couche semiconductrice, le procédé comprenant en outre, entre l'étape a) et l'étape b), une étape de retrait du substrat de support.

Selon un mode de réalisation, le procédé comporte en outre, après l'étape b), une étape de dépôt, sur chaque diode, d'une électrode sur et en contact avec la face de la première couche semiconductrice opposée à la deuxième couche semiconductrice.

Selon un mode de réalisation, les électrodes forment une grille métallique continue agencée de façon que, au niveau de chaque diode, dans une partie périphérique de la diode, la face de la première couche semiconductrice opposée à la deuxième couche semiconductrice soit en contact avec la grille, et, dans une partie centrale de la diode, la face de la première couche semiconductrice ne soit pas revêtue par la grille.

Selon un mode de réalisation, les électrodes forment une couche continue en un matériau conducteur transparent, revêtant sensiblement toute la surface du dispositif.

Selon un mode de réalisation, les diodes semiconductrices sont des diodes électroluminescentes.

Selon un mode de réalisation, le procédé comporte en outre, après l'étape b), une étape de report, sur la face du dispositif opposée au circuit de contrôle, d'un empilement de conversion photoluminescent à puits quantiques multiples revêtant sensiblement toute la surface du dispositif.

Selon un mode de réalisation, le procédé comprend en outre, après le report de l'empilement de conversion, une étape de retrait de l'empilement de conversion en regard de certaines seulement des diodes semiconductrices.

Selon un mode de réalisation, les diodes sont des photodiodes.

Selon un mode de réalisation, les première et deuxième couches semiconductrices sont des couches de nitrure de gallium, les diodes étant des diodes au nitrure de gallium.

### Brève description des dessins

Ces caractéristiques et leurs avantages, ainsi que d'autres, seront exposés en détail dans la description suivante de modes de réalisation particuliers faite à titre non limitatif en relation avec les figures jointes parmi lesquelles :
les figures 1A, 1B, 1C, 1D, 1E, 1F, 1G, 1H, 1I sont des vues en coupe illustrant des étapes d'un exemple d'un mode de réalisation d'un procédé de fabrication d'un dispositif optoélectronique ;
la figure 2 est une vue en coupe illustrant une variante de réalisation du procédé des figures 1A, 1B, 1C, 1D, 1E, 1F, 1G, 1H, 1I ; et
les figures 3A, 3B, 3C, 3D sont des vues en coupe illustrant une autre variante de réalisation du procédé des figures 1A, 1B, 1C, 1D, 1E, 1F, 1G, 1H, 1I.

### Description détaillée

De mêmes éléments ont été désignés par de mêmes références aux différentes figures et, de plus, les diverses figures ne sont pas tracées à l'échelle. Par souci de clarté, seuls les éléments qui sont utiles à la compréhension des modes de réalisation décrits ont été représentés et sont détaillés. En particulier, la réalisation d'un circuit intégré de contrôle de diodes au nitrure de gallium n'a pas été détaillée, les modes de réalisation décrits étant compatibles avec les structures et procédés de fabrication usuels de tels circuits de contrôle. De plus, la composition et l'agencement des différentes couches d'un empilement actif de diode au nitrure de gallium n'ont pas été détaillés, les modes de réalisation décrits étant compatibles avec les empilements actifs usuels de diode au nitrure de gallium. Dans la description qui suit, sauf indication contraire, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", "latéral", etc., il est fait référence à l'orientation des figures correspondantes, étant entendu que, dans la pratique, les dispositifs et assemblages décrits peuvent être orientés différemment. Sauf précision contraire, les expressions "approximativement", "sensiblement", et "de l'ordre de" signifient à 10 % près, de préférence à 5 % près.

Selon un aspect d'un mode de réalisation, on prévoit, pour fabriquer un dispositif optoélectronique comportant une pluralité de LEDs au nitrure de gallium et un circuit électronique de contrôle de ces LEDs, de :
réaliser d'abord le circuit de contrôle sous la forme d'un circuit intégré comportant, sur une face, une pluralité de plots métalliques destinés à être connectés aux LEDs de façon à pouvoir contrôler, par exemple de façon individuelle, le courant circulant dans les LEDs ;
rapporter ensuite sur la face du circuit de contrôle comportant les plots métalliques un empilement actif de LED au nitrure de gallium comportant au moins des première et deuxième couches de nitrure de gallium dopées de types de conductivité opposés, de façon que l'une des première et deuxième couches de nitrure de gallium de l'empilement soit électriquement en contact avec les plots métalliques du circuit de contrôle ; puis
structurer l'empilement actif pour délimiter dans l'empilement les différentes LEDs du dispositif.

Un avantage de ce procédé de fabrication est que, lors de l'étape de report de l'empilement actif de LED au nitrure de gallium sur le circuit de contrôle, les positions des différentes LEDs du dispositif dans l'empilement actif ne sont pas encore définies. Il n'y a par conséquent pas de contrainte forte en termes de précision d'alignement lors du report. La délimitation des différentes LEDs dans l'empilement actif peut ensuite être réalisée par des procédés de structuration d'un substrat et de dépôt de couches isolantes et conductrices sur un substrat, qui offrent une précision d'alignement nettement supérieure à la précision qui peut être obtenue lors d'un report d'un substrat sur un autre.

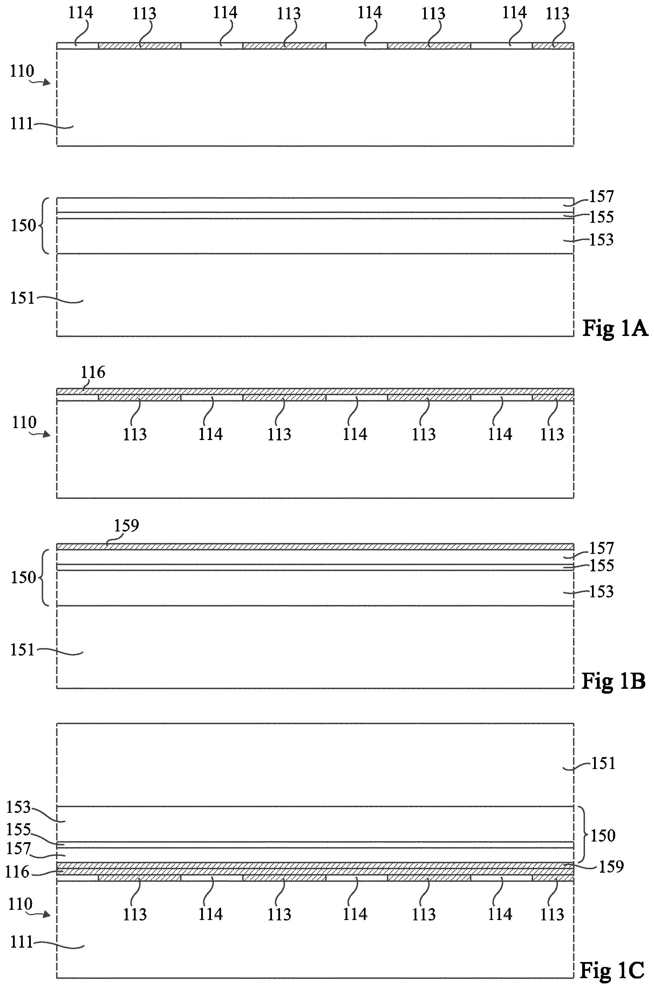

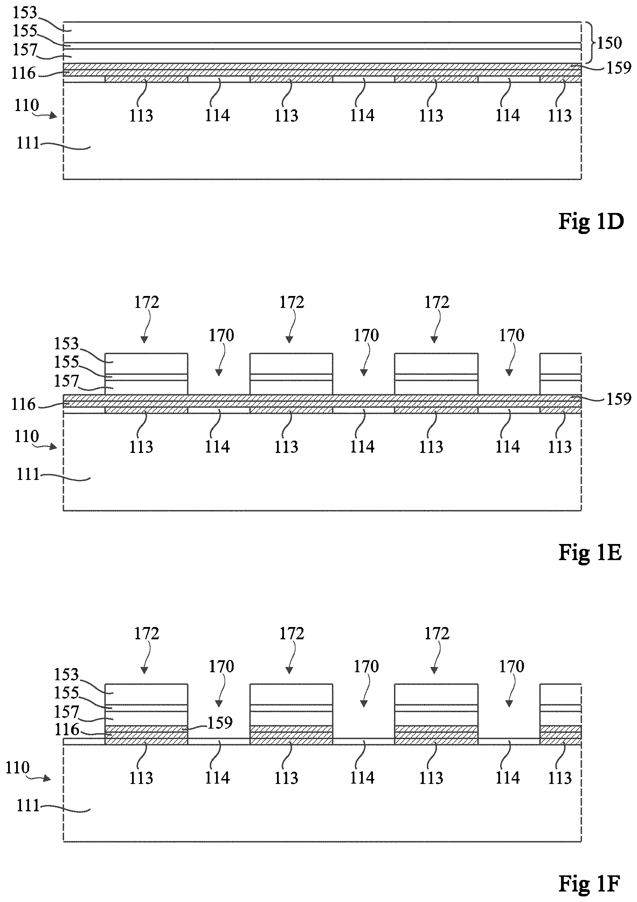

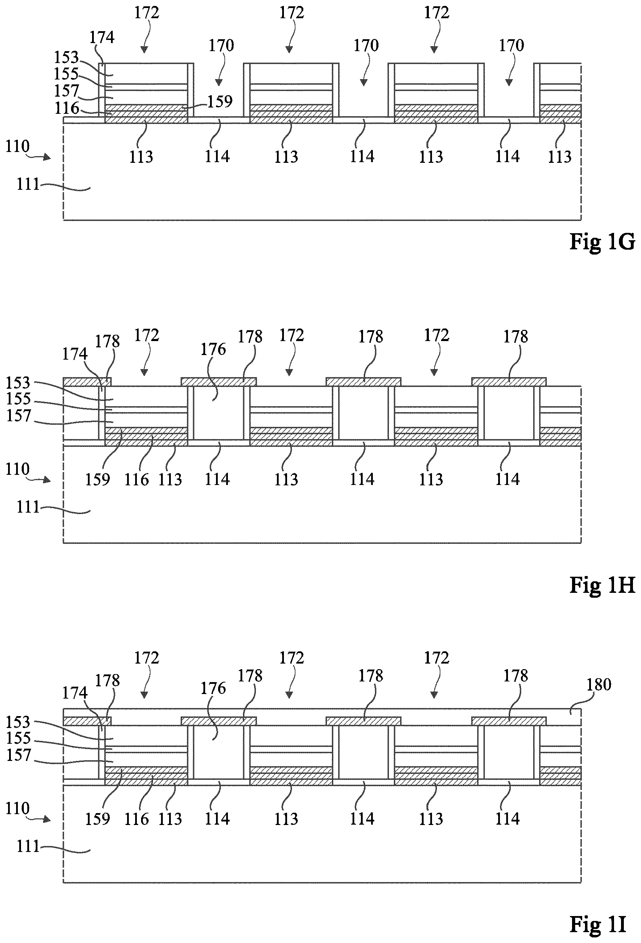

Les figures 1A, 1B, 1C, 1D, 1E, 1F, 1G, 1H, 1I sont des vues en coupe illustrant des étapes d'un exemple d'un mode de réalisation d'un procédé de fabrication d'un dispositif optoélectronique.

La figure 1A représente de façon schématique un circuit intégré de contrôle 110, préalablement formé dans et sur un substrat semiconducteur 111, par exemple un substrat en silicium. Dans cet exemple, le circuit de contrôle 110 comprend, du côté de sa face supérieure, pour chacune des LEDs du dispositif, un plot métallique de connexion 113 destiné à être connecté à l'une des électrodes (anode ou cathode) de la LED, de façon à pouvoir commander un courant circulant dans la LED et/ou appliquer une tension aux bornes de la LED. Le circuit de contrôle comprend par exemple, pour chaque LED, connectée au plot métallique 113 dédié à la LED, une cellule élémentaire de contrôle comportant un ou plusieurs transistors, permettant de contrôler le courant circulant dans la LED et/ou une tension appliquée aux bornes de la LED. Le circuit de contrôle 110 est par exemple réalisé en technologie CMOS. Les plots métalliques 113 peuvent être latéralement entourés par un matériau isolant 114, par exemple de l'oxyde de silicium, de façon que le circuit de contrôle 110 présente une surface supérieure sensiblement plane comprenant une alternance de régions métalliques 113 et de régions isolantes 114. Le contact sur les électrodes des LEDs (cathodes ou anodes) non connectées aux plots 113, peut être pris de façon collective, par exemple dans une région périphérique du circuit de contrôle 110, par l'intermédiaire d'un ou plusieurs plots de connexion (non visibles sur la figure) du circuit de contrôle 110.

La figure 1A représente en outre de façon schématique un empilement actif de LED au nitrure de gallium 150, disposé sur la face supérieure d'un substrat de support 151. Le substrat de support 151 est par exemple un substrat en silicium, en saphir, en corindon, ou en tout autre matériau sur lequel un empilement actif de LED au nitrure de gallium peut être déposé. Dans l'exemple représenté, l'empilement actif comprend, dans l'ordre à partir de la surface supérieure du substrat 151, une couche de nitrure de gallium dopé de type N 153, une couche émissive 155, et une couche de nitrure de gallium dopé de type P 157. La couche émissive 155 est par exemple constituée par un empilement d'une ou plusieurs couches émissives formant chacune un puit quantique, par exemple à base de GaN, InN, InGaN, AlGaN, AlN, AlInGaN, GaP, AlGaP, AlInGaP, ou d'une combinaison d'un ou plusieurs de ces matériaux. A titre de variante, la couche émissive 155 peut être une couche de nitrure de gallium intrinsèque, c'est-à-dire non intentionnellement dopée, par exemple de concentration en donneurs résiduels comprise entre 10¹⁵ et 10¹⁸ atomes/cm³, par exemple de l'ordre de 10¹⁷ atomes/cm³. Dans cet exemple, la face inférieure de la couche émissive 155 est en contact avec la face supérieure de la couche 153, et la face supérieure de la couche émissive 155 est en contact avec la face inférieure de la couche 157. En pratique, selon la nature du substrat 151, un empilement d'une ou plusieurs couches tampon (non représentées) peut faire interface entre le substrat de support 151 et la couche de nitrure de gallium 153. L'empilement actif 150 est par exemple déposé par épitaxie sur le substrat de support 151.

La figure 1B illustre une étape de dépôt, sur la face supérieure du circuit de contrôle 110, d'une couche métallique 116. Dans l'exemple représenté, la couche métallique 116 revêt sensiblement toute la surface supérieure du circuit de contrôle 110. En particulier, la couche métallique 116 est en contact avec les plots métalliques de connexion 113 du circuit de contrôle 110.

La figure 1B illustre en outre une étape de dépôt, sur la face supérieure de l'empilement actif de diode au nitrure de gallium 150, d'une couche métallique 159. Dans l'exemple représenté, la couche métallique 159 est disposée sur et en contact avec la face supérieure de la couche de nitrure de gallium 157. La couche métallique 159 revêt par exemple sensiblement toute la surface supérieure de l'empilement actif.

La figure 1C illustre une étape au cours de laquelle l'empilement actif de LED au nitrure de gallium 150 est rapporté sur la face supérieure du circuit de contrôle 110. Pour cela, l'ensemble comportant le substrat de support 151 et l'empilement actif 150 peut être retourné, puis rapporté sur le circuit de contrôle 110, de façon à mettre en contact la face supérieure (dans l'orientation de la figure 1B) de la couche métallique 159 avec la face supérieure de la couche métallique 116. Au cours de cette étape, l'empilement actif 150 est fixé (bonded) au circuit de contrôle 110. A titre d'exemple, la fixation de l'empilement actif 150 sur le circuit de contrôle 110 peut être obtenue par collage moléculaire entre les deux surfaces mises en contact. A titre de variante, la fixation des deux surfaces peut être réalisée par thermocompression, collage eutectique, ou par toute autre méthode de fixation adaptée.

La figure 1D illustre une étape postérieure à l'étape de report de la figure 1C, au cours de laquelle le substrat de support 151 de l'empilement actif de LED au nitrure de gallium 150 est retiré de façon à découvrir la face supérieure de la couche de nitrure de gallium 153. Le substrat 151 est par exemple retiré par meulage et/ou gravure à partir de sa face opposée à l'empilement actif 150. A titre de variante, dans le cas d'un substrat 151 transparent, par exemple un substrat en saphir ou en corindon, le substrat 151 peut être détaché de l'empilement actif 150 au moyen d'un faisceau laser projeté à travers le substrat 151 depuis sa face opposée à l'empilement actif 150 (procédé de type laser lift-off). Plus généralement, toute autre méthode permettant de retirer le substrat 151 peut être utilisée. Après le retrait du substrat, une étape supplémentaire de gravure peut être prévue pour retirer d'éventuelles couches tampon subsistant du côté de la face supérieure de la couche de nitrure de gallium 153. En outre, une partie de l'épaisseur de la couche de nitrure de gallium 153 peut être retirée, par exemple par gravure. A l'issue de cette étape, l'empilement actif 150 revêt sensiblement toute la surface du circuit de contrôle 110, sans discontinuité. A titre d'exemple, l'épaisseur de l'empilement actif 150 à l'issue de l'étape de la figure 1D est comprise entre 0,5 et 2 µm.

La figure 1E illustre une étape postérieure à l'étape de la figure 1D, au cours de laquelle des tranchées sont formées dans l'empilement actif 150, depuis sa face supérieure, par exemple par lithographie puis gravure, de façon à délimiter une pluralité de LEDs au nitrure de gallium 172. Chaque LED 172 correspond à un îlot ou mesa formé dans l'empilement 150 et entouré latéralement par une tranchée 170. Les tranchées 170 s'étendent verticalement sur toute la hauteur de l'empilement 150. Ainsi, chaque LED 172 comprend un empilement vertical comportant, dans l'ordre à partir de la surface supérieure de la couche métallique 159, une portion de la couche de nitrure de gallium 157, correspondant à l'anode de la LED dans cet exemple, une portion de la couche émissive 155, et une portion de la couche de nitrure de gallium 153, correspondant à la cathode de la LED dans cet exemple. Les tranchées 170 peuvent être alignées sur des repères préalablement formés sur le circuit de contrôle 110. Dans l'exemple représenté, chaque LED 172 est située, en projection verticale, en regard d'un unique plot métallique 113 du circuit de contrôle 110. Dans cet exemple, les tranchées 170 sont situées, en projection verticale, en regard des régions isolantes 114 de la face supérieure du circuit de contrôle 110. Dans l'exemple représenté, la couche métallique 159 sert de couche d'arrêt de gravure lors de la réalisation des tranchées 170 dans l'empilement actif 150.

La figure 1F illustre une étape ultérieure de retrait, par exemple par gravure, des portions des couches métalliques 159 et 116 situées au fond des tranchées 170, de façon à prolonger les tranchées 170 jusqu'aux régions isolantes 114 de la face supérieure du circuit de contrôle 110. A l'issue de cette étape, les anodes (régions 157) des différentes LEDs 172 sont isolées électriquement les unes des autres par les tranchées 170, et chaque LED 172 a son anode connectée au plot métallique 113 sous-jacent par l'intermédiaire des portions de couches métalliques 159 et 116 subsistant entre la LED et le plot 113. Ceci permet un contrôle individuel des LEDs par le circuit de contrôle 110.

La figure 1G illustre une étape ultérieure de dépôt, sur les flancs des LEDs 172, d'une couche isolante de passivation 174, par exemple en oxyde de silicium. La couche 174 est par exemple déposée sur toute la surface supérieure de l'assemblage par une technique de dépôt conforme, puis retirée uniquement sur la face supérieure des LEDs 172 et au fond des tranchées 170, par exemple par gravure anisotrope.

La figure 1H illustre une étape postérieure à l'étape de la figure 1G, au cours de laquelle les tranchées 170 sont comblées par un matériau isolant 176, par exemple de l'oxyde de silicium. A titre d'exemple, une couche d'oxyde de silicium suffisamment épaisse pour combler les tranchées 170 est déposée sur toute la surface supérieure de l'assemblage, puis une étape de planarisation, par exemple une planarisation mécanochimique (CMP), est mise en oeuvre pour retirer l'oxyde de silicium sur la surface supérieure des LEDs 172. A l'issue de cette étape, la face supérieure de l'assemblage est sensiblement plane et comprend une alternance de régions isolantes 174, 176 et de régions de nitrure de gallium 153. En variante, l'étape de remplissage des tranchées 170 (figure 1H) et l'étape de passivation des flancs des LEDs (figure 1G) peuvent être combinées.

La figure 1H illustre en outre une étape postérieure au remplissage des tranchées 170 par le matériau isolant 176, au cours de laquelle une ou plusieurs métallisations 178 sont formées sur la face supérieure du dispositif, en contact avec les régions de cathode 153 des LEDs 172. Dans cet exemple, les régions de cathode des LEDs 172 sont toutes connectées à une même métallisation 178. La métallisation 178 forme une grille venant contacter, sur chacune des LEDs 172, une partie périphérique de la face supérieure de la région de cathode 153 de la LED. Au niveau de chacune des LEDs 172, une partie centrale de la LED n'est en revanche pas recouverte par la grille métallique 178, de façon à permettre le passage de la lumière émise par la LED. En effet, dans l'exemple représenté, le dispositif d'affichage est destiné à être observé du côté de sa face supérieure. La grille métallique 178 peut être connectée au circuit de contrôle 110, par exemple par l'intermédiaire d'un ou plusieurs vias (non représentés) formés dans l'empilement actif 150 ou dans le matériau isolant 176 de remplissage des tranchées 170, par exemple dans une région périphérique du dispositif.

La figure 1I illustre une étape postérieure au dépôt des métallisations 178, au cours de laquelle une couche isolante 180, par exemple en oxyde de silicium, est déposée sur sensiblement toute la surface supérieure du dispositif, pour protéger les métallisations 178 et les portions apparentes de la couche de nitrure de gallium 153. La couche isolante 180 peut être planarisée de façon à obtenir un dispositif d'affichage présentant une surface supérieure sensiblement plane.

Dans l'exemple de réalisation décrit en relation avec les figures 1A à 1I, le dépôt des couches métalliques 116 et 159 sur le circuit de contrôle 110 et sur l'empilement actif 150 (étape de la figure 1B) préalablement au report de l'empilement actif 150 sur le circuit de contrôle 110 (étape de la figure 1C) présente plusieurs avantages.

En particulier, les couches 116 et 159 permettent d'améliorer la qualité du collage entre les deux structures. En effet, bien que possible, le collage direct de la face supérieure (dans l'orientation de la figure 1A) de la couche de nitrure de gallium 157 sur la surface supérieure du circuit de contrôle 110 (comprenant une alternance de régions isolantes 114 et de régions métalliques 113) est relativement délicat à réaliser.

En outre, la couche 159 peut avantageusement être choisie pour réaliser un bon contact ohmique avec la couche de nitrure de gallium 157. Le matériau des plots métalliques 113 du circuit de contrôle 110, par exemple du cuivre ou de l'aluminium, peut en effet ne pas être adapté à la réalisation d'un tel contact ohmique.

De plus, les couches 116 et/ou 159 peuvent comprendre un métal réfléchissant pour la lumière émise par les LEDs 172, de façon à augmenter l'efficacité d'émission et éviter des déperditions de lumière dans le circuit de contrôle 110.

Par ailleurs, la couche 116 et/ou la couche 159 peuvent être choisies de façon à éviter que du métal des plots de connexion 113 du circuit de contrôle, par exemple du cuivre, ne diffuse vers la couche de nitrure de gallium 157, ce qui pourrait notamment dégrader la qualité du contact ohmique avec la couche de nitrure de gallium 157.

En pratique, chacune des couches 116 et 159 peut être une couche unique ou un empilement d'une ou plusieurs couches de métaux différents permettant d'assurer tout ou partie des fonctions susmentionnées.

Dans le procédé de l'invention, la couche 116 comprend une couche supérieure en un métal de même nature qu'une couche supérieure (dans l'orientation de la figure 1B) de la couche 159, ce métal étant choisi pour obtenir un bon collage entre les deux structures lors de l'étape de la figure 1C, par exemple un métal du groupe comprenant le Ti, le Ni, le Pt, le Sn, l'Au, l'Ag, l'Al, le Pd, le W, le Pb, le Cu, l'AuSn, le TiSn, le NiSn ou un alliage de tout ou partie de ces matériaux. L'empilement formé par les couches 116 et 159 peut en outre comprendre une ou plusieurs couches en des métaux adaptés à réfléchir la lumière émise par les LEDs, par exemple de l'argent. De plus, l'empilement formé par les couches 116 et 159 peut comprendre une ou plusieurs couches adaptées à faire barrière à la diffusion de métaux tels que le cuivre ou l'argent compris dans l'empilement 116/159 et/ou dans les plots métalliques 113, par exemple des couches de TaN, TiN, WN, TiW, ou d'une combinaison de tout ou partie de ces matériaux.

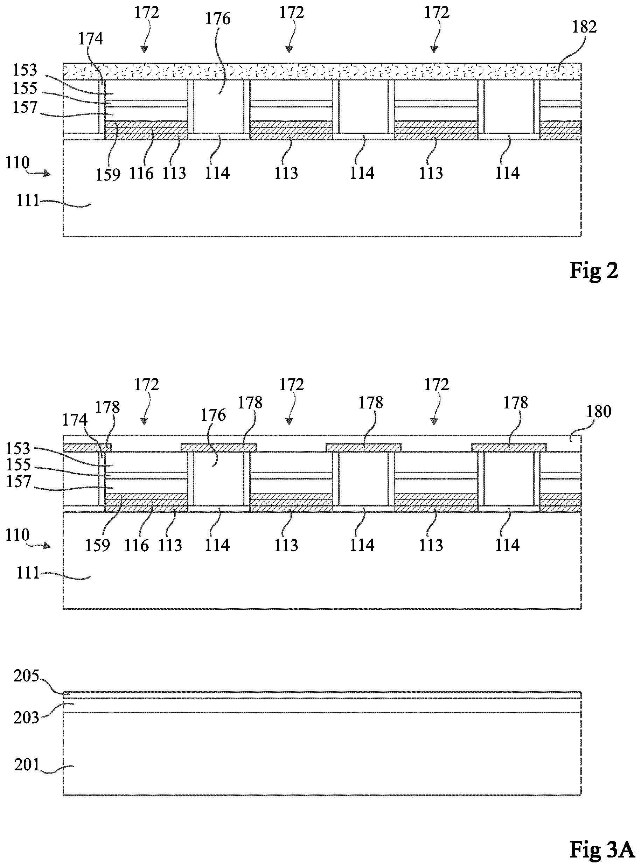

La figure 2 est une vue en coupe illustrant une variante de réalisation du procédé des figures 1A, 1B, 1C, 1D, 1E, 1F, 1G, 1H, 1I. Le procédé de la figure 2 diffère du procédé décrit précédemment essentiellement en ce que, à l'étape de la figure 1H, après le remplissage des tranchées 170 par le matériau isolant 176, le contact sur les régions de cathode des LEDs 172 est réalisé non pas au moyen d'une métallisation 178 en un matériau opaque, mais par une électrode 182 en un matériau conducteur transparent, par exemple en ITO (oxyde d'indium étain). Dans l'exemple représenté, l'électrode 182 est une électrode continue revêtant sensiblement toute la surface supérieure du dispositif. En particulier, dans cet exemple, l'électrode 182 recouvre sensiblement toute la surface supérieure des LEDs 172. L'électrode 182 peut être connectée au circuit de contrôle 110, par exemple par l'intermédiaire d'un ou plusieurs vias (non représentés) formés dans l'empilement actif 150 ou dans le matériau isolant 176 de remplissage des tranchées 170, par exemple dans une région périphérique du dispositif.

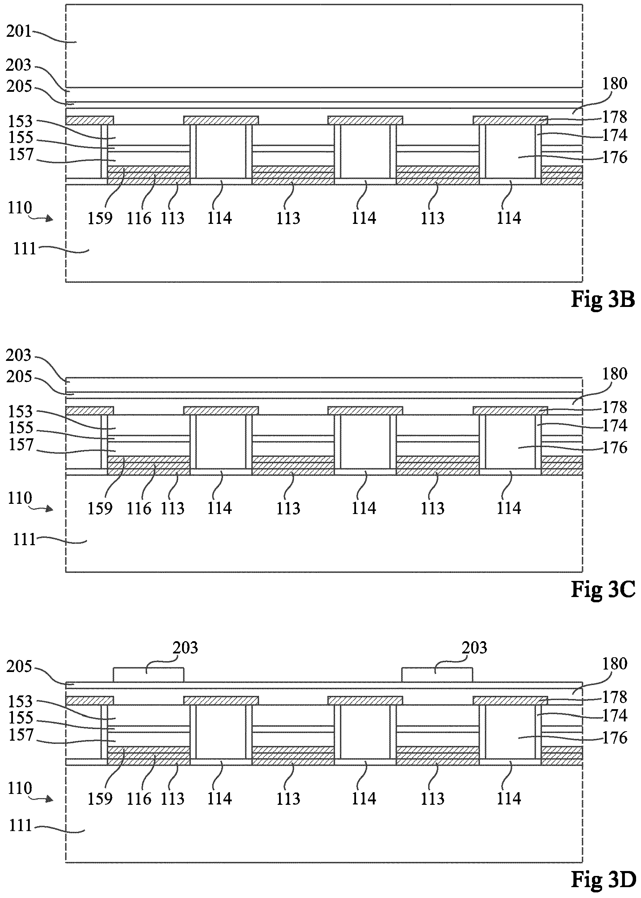

Les figures 3A, 3B, 3C, 3D sont des vues en coupe illustrant des étapes d'une autre variante de réalisation du procédé des figures 1A, 1B, 1C, 1D, 1E, 1F, 1G, 1H, 1I, adaptée à la réalisation d'un dispositif d'affichage d'images couleur. En effet, dans l'exemple des figures 1A, 1B, 1C, 1D, 1E, 1F, 1G, 1H, 1I, les LEDs 172 sont toutes sensiblement identiques, et émettent sensiblement à la même longueur d'onde. Le dispositif obtenu à l'issue de l'étape de la figure 1I est donc un dispositif d'affichage monochromatique.

Le procédé des figures 3A, 3B, 3C, 3D est mis en oeuvre en partant du dispositif obtenu à l'issue du procédé des figures 1A, 1B, 1C, 1D, 1E, 1F, 1G, 1H, 1I. Cette structure est représentée à nouveau sur la figure 3A.

La figure 3A illustre en outre de façon schématique une étape de formation, sur la face supérieure d'un substrat de support 201, par exemple un substrat de GaAs, d'un empilement 203 de conversion photoluminescent à puits quantiques multiples. L'empilement 203 comprend une pluralité de couches définissant chacune un puit quantique. L'empilement 203 est adapté à absorber des photons à la longueur d'onde d'émission des LEDs 172, et à réémettre des photons à une autre longueur d'onde. A titre d'exemple, l'empilement 203 est adapté à convertir de la lumière bleue en lumière rouge ou de la lumière bleue en lumière verte. L'empilement de conversion 203 est par exemple réalisé par épitaxie sur le substrat de support 201.

Dans l'exemple représenté, une couche de revêtement 205, par exemple une couche d'oxyde (par exemple de l'oxyde de silicium), est déposée sur et en contact avec la surface supérieure de l'empilement de conversion 203, la couche 205 s'étendant sur sensiblement toute la surface supérieure de l'empilement de conversion 203.

La figure 3B illustre une étape au cours de laquelle l'empilement de conversion 203 est rapporté sur la surface supérieure du dispositif d'affichage. Pour cela, l'ensemble comportant le substrat de support 201 et l'empilement de conversion 203 peut être retourné, puis rapporté sur le dispositif d'affichage, de façon à mettre en contact la face supérieure (dans l'orientation de la figure 3A) de la couche de revêtement 205 avec la face supérieure de la couche supérieure 180 du dispositif d'affichage. Au cours de cette étape, l'empilement de conversion 203 est fixé (bonded) au dispositif d'affichage. A titre d'exemple, la fixation de l'empilement actif 203 sur le dispositif d'affichage peut être obtenue par collage moléculaire entre les deux surfaces mises en contact. A titre de variante, la fixation des deux surfaces peut être réalisée par thermocompression, collage eutectique, ou par toute autre méthode de fixation adaptée. La couche de revêtement 205 permet de favoriser le collage des deux structures. Toutefois, en variante, la couche 205 peut être omise, la surface supérieure (dans l'orientation de la figure 3A) de l'empilement de conversion 203 étant alors mise en contact directement avec la face supérieure du dispositif d'affichage.

La figure 3C illustre une étape postérieure à l'étape de report de la figure 3B, au cours de laquelle le substrat de support 201 de l'empilement de conversion 203 est retiré. Le substrat 201 est par exemple retiré par meulage et/ou gravure chimique à partir de sa face supérieure, c'est-à-dire sa face opposée à l'empilement de conversion 203. A l'issue de cette étape, l'empilement de conversion 203 revêt sensiblement toute la surface du dispositif d'affichage, sans discontinuité.

La figure 3D illustre une étape postérieure à l'étape de la figure 3C, au cours de laquelle des portions de l'empilement de conversion 203 sont retirées, par exemple par gravure sèche, en regard de certaines parties du dispositif d'affichage. Plus particulièrement, lors de cette étape, l'empilement de conversion 203 peut être retiré au-dessus de certaines LEDs 172, et conservé au-dessus des autres LEDs 172. On obtient ainsi un dispositif d'affichage comportant des premiers pixels adaptés à émettre de la lumière à une première longueur d'onde, et des deuxièmes pixels adaptés à émettre de la lumière à une deuxième longueur d'onde.

En variante, pour augmenter le nombre de couleurs susceptibles d'être affichées par le dispositif, les étapes des figures 3A, 3B, 3C, 3D peuvent être répétées plusieurs fois pour déposer des empilements de conversion photoluminescents à puits quantiques multiples présentant des propriétés de conversion différentes.

Par ailleurs, à titre de variante, le procédé des figures 3A, 3B, 3C, 3D peut être mis en oeuvre en prenant comme structure de départ le dispositif d'affichage monochromatique de la figure 2.

Des modes de réalisation particuliers ont été décrits. Diverses variantes et modifications apparaîtront à l'homme de l'art. En particulier, les types de conductivité des couches de nitrure de gallium 153 (de type N dans les exemples décrits) et 157 (de type P dans les exemples décrits) peuvent être inversés.

En outre, des étapes supplémentaires peuvent être prévues pour réaliser, du côté de la face supérieure des dispositifs d'affichage des structures adaptées à améliorer l'extraction de la lumière émise par les LEDs.

Par ailleurs, bien que l'on ait décrit uniquement des exemples de réalisation de dispositifs d'affichage à base de LEDs au nitrure de gallium, les modes de réalisation décrits peuvent être adaptés à la fabrication d'un capteur comportant une pluralité de photodiodes au nitrure de gallium adressables individuellement pour acquérir une image.

Plus généralement, les modes de réalisation décrits peuvent être adaptés à la fabrication de tout dispositif d'affichage ou capteur photosensible à base de diodes semiconductrices, y compris à base de matériaux semiconducteurs autres que le nitrure de gallium, par exemple des diodes à base d'autres matériaux semi-conducteurs III-V ou des diodes à base de silicium.

## Revendications

1. Procédé de fabrication d'un dispositif optoélectronique, comportant les étapes successives suivantes :
a) rapporter, sur une face d'un circuit intégré de contrôle (110) préalablement formé dans et sur un substrat semiconducteur et comportant une pluralité de plots métalliques (113) de connexion, un empilement actif (150) de diode comportant au moins des première (153) et deuxième (157) couches semiconductrices dopées de types de conductivité opposés, de façon que la deuxième couche (157) de l'empilement soit électriquement connectée aux plots métalliques (113) du circuit de contrôle (110) ; et
b) former dans l'empilement actif (150) des tranchées (170) délimitant une pluralité de diodes (172) connectées à des plots métalliques (113) distincts du circuit de contrôle (110),
dans lequel, à l'étape a), les couches métalliques suivantes font interface entre le circuit intégré de contrôle (102) et l'empilement actif (150) :
une première couche métallique (116) s'étendant sur sensiblement toute la surface du circuit de contrôle (110) côté plots métalliques (113) ; et
une deuxième couche métallique (159) s'étendant sur sensiblement toute la surface de la deuxième couche (157) semiconductrice opposée à la première couche (153) semiconductrice,
dans lequel, à l'étape a), l'empilement actif (150) de diode est fixé sur le circuit de contrôle (110) par collage moléculaire de la première couche métallique (116) sur la deuxième couche métallique (159),
dans lequel la première couche métallique (116) comprend une couche supérieure en un métal de même nature qu'une couche supérieure de la deuxième couche métallique (159), la fixation de l'empilement actif (150) de diode sur le circuit de contrôle (110) étant obtenue par mise en contact direct desdites couches supérieures l'une avec l'autre.

2. Procédé selon la revendication 1, dans lequel le circuit intégré de contrôle (110) est réalisé en technologie CMOS.

3. Procédé selon la revendication 1 ou 2, dans lequel, à l'étape b), les tranchées (170) sont alignées sur des repères préalablement formés sur le circuit de contrôle (110).

4. Procédé selon l'une quelconque des revendications 1 à 3, dans lequel au moins l'une des première (116) et deuxième (159) couches métalliques comprend une couche réfléchissante en argent.

5. Procédé selon l'une quelconque des revendications 1 à 4, dans lequel au moins l'une des première (116) et deuxième (159) couches métalliques comprend une couche barrière en TaN, TiN, WN, TiW, ou en une combinaison d'un ou plusieurs de ces matériaux.

6. Procédé selon l'une quelconque des revendications 1 à 5, dans lequel lesdites couches supérieures des première (116) et deuxième (159) couches métalliques sont en Ti, Ni, Pt, Sn, Au, Ag, Al, Pd, W, Pb, Cu, AuSn, TiSn, NiSn ou en un alliage de tout ou partie de ces matériaux.

7. Procédé selon l'une quelconque des revendications 1 à 6, dans lequel les tranchées (170) formées à l'étape b) s'étendent sur toute la hauteur de l'empilement actif (150) et traversent les première (116) et deuxième (159) couches métalliques.

8. Procédé selon l'une quelconque des revendications 1 à 7, dans lequel, lors de la mise en oeuvre de l'étape a), l'empilement actif (150) est supporté par un substrat de support (201) situé du côté de la première couche (153) semiconductrice opposé à la deuxième couche (157) semiconductrice, le procédé comprenant en outre, entre l'étape a) et l'étape b), une étape de retrait du substrat de support (201).

9. Procédé selon l'une quelconque des revendications 1 à 8, comportant en outre, après l'étape b), une étape c) de dépôt, sur chaque diode (172), d'une électrode (178 ; 182) sur et en contact avec la face de la première couche (153) semiconductrice opposée à la deuxième couche (157) semiconductrice.

10. Procédé selon la revendication 9, dans lequel lesdites électrodes (178) forment une grille métallique continue agencée de façon que, au niveau de chaque diode (172), dans une partie périphérique de la diode (172), la face de la première couche (153) semiconductrice opposée à la deuxième couche (157) semiconductrice soit en contact avec la grille, et, dans une partie centrale de la diode (172), la face de la première couche (153) semiconductrice ne soit pas revêtue par la grille.

11. Procédé selon la revendication 10, dans lequel lesdites électrodes (182) forment une couche continue en un matériau conducteur transparent, revêtant sensiblement toute la surface du dispositif.

12. Procédé selon l'une quelconque des revendications 9 à 11, comprenant en outre, après l'étape b) et avant l'étape c), une étape au cours de laquelle les tranchées (170) sont comblées par un matériau isolant (176), et une étape de planarisation pour retirer le matériau isolant sur la surface supérieure des diodes.

13. Procédé selon l'une quelconque des revendications 1 à 12, dans lequel lesdites diodes (172) semiconductrices sont des diodes électroluminescentes.

14. Procédé selon la revendication 13, comportant en outre, après l'étape b), une étape de report, sur la face du dispositif opposée au circuit de contrôle (110), d'un empilement de conversion (203) photoluminescent à puits quantiques multiples revêtant sensiblement toute la surface du dispositif.

15. Procédé selon la revendication 14, comprenant en outre, après le report de l'empilement de conversion (203), une étape de retrait de l'empilement de conversion (203) en regard de certaines seulement des diodes (172) semiconductrices.

16. Procédé selon l'une quelconque des revendications 1 à 12, dans lequel lesdites diodes sont des photodiodes.

17. Procédé selon l'une quelconque des revendications 1 à 16, dans lequel les première (153) et deuxième (157) couches semiconductrices sont des couches de nitrure de gallium, lesdites diodes (172) étant des diodes au nitrure de gallium.

## Patentansprüche

1. Verfahren zur Herstellung einer optoelektronischen Vorrichtung, das die folgenden aufeinanderfolgenden Schritte aufweist:
a) Übertragen eines aktiven Diodenstapels (150), der mindestens eine erste (153) und eine zweite (157) dotierte Halbleiterschicht entgegengesetzter Leitfähigkeitstypen aufweist, auf eine Oberfläche einer zuvor innerhalb und auf einem Halbleitersubstrat ausgebildeten integrierten Steuerschaltung (110), die mehrere Verbindungs-Metallpads (113) aufweist, so dass die zweite Schicht (157) des Stapels elektrisch mit den Metallpads (113) der Steuerschaltung (110) verbunden ist; und
b) Ausbilden von Gräben (170) in dem aktiven Stapel (150), die mehrere Dioden (172) begrenzen, die mit verschiedenen Metallpads (113) der Steuerschaltung (110) verbunden sind,
wobei in Schritt a) die folgenden Metallschichten zwischen der integrierten Steuerschaltung (102) und dem aktiven Stapel (150) ein Interface bilden:
eine erste Metallschicht (116), die sich im Wesentlichen über die gesamte Oberfläche der Steuerschaltung (110) auf der Seite der Metallpads (113) erstreckt; und
eine zweite Metallschicht (159), die sich im Wesentlichen über die gesamte Oberfläche der zweiten Halbleiterschicht (157) entgegengesetzt zur ersten Halbleiterschicht (153) erstreckt,
wobei in Schritt a) der aktive Diodenstapel (150) durch molekulares Bonden der ersten Metallschicht (116) mit der zweiten Metallschicht (159) mit der Steuerschaltung (110) gebondet wird,
und wobei die erste Metallschicht (116) eine obere Schicht aus einem Metall derselben Art wie eine obere Schicht der zweiten Metallschicht (159) aufweist, wobei das Bonden des aktiven Diodenstapels (150) mit der Steuerschaltung (110) durch direkten Kontakt der oberen Schichten miteinander erreicht wird.

2. Verfahren nach Anspruch 1, wobei die integrierte Steuerschaltung (110) in CMOS-Technologie hergestellt ist.

3. Verfahren nach Anspruch 1 oder 2, wobei in Schritt b) Gräben (170) mit zuvor auf der Steuerschaltung (110) ausgebildeten Markierungen ausgerichtet werden.

4. Verfahren nach einem der Ansprüche 1 bis 3, wobei mindestens eine der ersten (116) und zweiten (159) Metallschichten eine reflektierende Silberschicht aufweist.

5. Verfahren nach einem der Ansprüche 1 bis 4, wobei mindestens eine der ersten (116) und zweiten (159) Metallschichten eine Barriereschicht aus TaN, TiN, WN, TiW oder einer Kombination aus einem oder mehreren dieser Materialien aufweist.

6. Verfahren nach einem der Ansprüche 1 bis 5, wobei die oberen Schichten der ersten (116) und zweiten (159) Metallschichten aus Ti, Ni, Pt, Sn, Au, Ag, Al, Pd, W, Pb, Cu, AuSn, TiSn, NiSn oder einer Legierung aus allen oder einem Teil dieser Materialien bestehen.

7. Verfahren nach einem der Ansprüche 1 bis 6, wobei die in Schritt b) ausgebildeten Gräben (170) sich über die gesamte Höhe des aktiven Stapels (150) erstrecken und die erste (116) und zweite (159) Metallschicht kreuzen.

8. Verfahren nach einem der Ansprüche 1 bis 7, wobei während der Durchführung des Schritts a) der aktive Stapel (150) von einem Trägersubstrat (201) getragen wird, das sich auf der der zweiten Halbleiterschicht (157) entgegengesetzten Seite der ersten Halbleiterschicht (153) angeordnet ist, wobei das Verfahren zwischen dem Schritt a) und dem Schritt b) einen Schritt zum Entfernen des Trägersubstrats (201) aufweist.

9. Verfahren nach einem der Ansprüche 1 bis 8, das ferner nach Schritt b) einen Schritt des Aufbringens einer Elektrode (178; 182) auf jeder Diode (172) auf und in Kontakt mit der Oberfläche der ersten Halbleiterschicht (153) entgegengesetzt zur zweiten Halbleiterschicht (157) aufweist.

10. Verfahren nach Anspruch 9, wobei die Elektroden (178) ein durchgehendes Metallgitter bilden, das so angeordnet ist, dass auf Höhe jeder Diode (172) in einem Randbereich der Diode (172) die der zweiten Halbleiterschicht (157) entgegengesetzte Oberfläche der ersten Halbleiterschicht (153) mit dem Gitter in Kontakt steht und in einem mittleren Bereich der Diode (172) die Oberfläche der ersten Halbleiterschicht (153) nicht mit dem Gitter bedeckt ist.

11. Verfahren nach Anspruch 9, wobei die Elektroden (182) eine durchgehende Schicht aus einem transparenten leitfähigen Material bilden, die im Wesentlichen die gesamte Oberfläche der Vorrichtung bedeckt.

12. Verfahren nach einem der Ansprüche 9 bis 11, das nach Schritt b) und vor Schritt c) einen Schritt aufweist, in dem Gräben (170) mit einem isolierenden Material (176) gefüllt werden, und einen Planarisierungsschritt zum Entfernen des Isoliermaterials von der Oberseite der Dioden.

13. Verfahren nach einem der Ansprüche 1 bis 12, wobei die Halbleiterdioden (172) Leuchtdioden sind.

14. Verfahren nach Anspruch 13, das nach Schritt b) einen Schritt aufweist, bei dem auf die Oberfläche der Vorrichtung entgegengesetzt zur Steuerschaltung (110) ein photolumineszenter Umwandlungsstapel (203) mit mehreren Quantentöpfen übertragen wird, der im Wesentlichen die gesamte Oberfläche der Vorrichtung bedeckt.

15. Verfahren nach Anspruch 14, das nach dem Übertragen des Umwandlungsstapels (203) einen Schritt aufweist, bei dem der Umwandlungsstapel (203) entgegengesetzt zu nur einigen der Halbleiterdioden (172) entfernt wird.

16. Verfahren nach einem der Ansprüche 1 bis 12, wobei die Dioden Fotodioden sind.

17. Verfahren nach einem der Ansprüche 1 bis 16, wobei die erste (153) und zweite (157) Halbleiterschicht Galliumnitridschichten sind, wobei die Dioden (172) Galliumnitriddioden sind.

## Claims

1. A method of manufacturing an optoelectronic device, comprising the successive steps of:
a) transferring, onto a surface of a control integrated circuit (110) previously formed inside and on a semiconductor substrate and comprising a plurality of metal connection pads (113), an active diode stack (150) comprising at least first (153) and second (157) doped semiconductor layers of opposite conductivity types, so that the second layer (157) of the stack is electrically connected to the metal pads (113) of the control circuit (110); and
b) forming in the active stack (150) trenches (170) delimiting a plurality of diodes (172) connected to different metal pads (113) of the control circuit (110),
wherein, at step a), the following metal layers interface between the control integrated circuit (102) and the active stack (150):
one first metal layer (116) extending over substantially the entire surface of the control circuit (110) on the side of the metal pads (113); and
one second metal layer (159) extending over substantially the entire surface of the second semiconductor layer (157) opposite to the first semiconductor layer (153),
wherein, at step a), the active diode stack (150) is bonded on the control circuit (110) by molecular bonding of the first metal layer (116) on the second metal layer (159),
and wherein the first metal layer (116) comprises an upper layer made of a metal of same nature as an upper layer of the second metal layer (159), the bonding of the active diode stack (150) on the control circuit (110) being obtained by direct contact of said upper layers one with each other.

2. The method of claim 1, wherein the control integrated circuit (110) is made in CMOS technology.

3. The method of claim 1 or 2, wherein, at step b), trenches (170) are aligned on marks previously formed on the control circuit (110).

4. The method of any of claims 1 to 3, wherein at least one of the first (116) and second (159) metal layers comprises a reflective silver layer.

5. The method of any of claims 1 to 4, wherein at least one of the first (116) and second (159) metal layers comprises a barrier layer made of TaN, TiN, WN, TiW or of a combination of one or a plurality of these materials.

6. The method of any of claims 1 to 5, wherein said upper layers of the first (116) and second (159) metal layers are made of Ti, Ni, Pt, Sn, Au, Ag, Al, Pd, W, Pb, Cu, AuSn, TiSn, NiSn, or of an alloy of all or part of these materials.

7. The method of any of claims 1 to 6, wherein the trenches (170) formed at step b) extend all along the height of the active stack (150) and cross the first (116) and second (159) metal layers.

8. The method of any of claims 1 to 7, wherein, during the implementation of step a), the active stack (150) is supported by a support substrate (201) located on the side of the first semiconductor layer (153) opposite to the second semiconductor layer (157), the method further comprising, between step a) and step b), a step of removing the support substrate (201).

9. The method of any of claims 1 to 8, further comprising, after step b), a step of depositing, on each diode (172), an electrode (178; 182) on top of and in contact with the surface of the first semiconductor layer (153) opposite to the second semiconductor layer (157).

10. The method of claim 9, wherein said electrodes (178) form a continuous metal grid arranged so that, at the level of each diode (172), in a peripheral portion of the diode (172), the surface of the first semiconductor layer (153) opposite to the second semiconductor layer (157) is in contact with the grid and, in a central portion of the diode (172), the surface of the first semiconductor layer (153) is not coated with the grid.

11. The method of claim 9, wherein said electrodes (182) form a continuous layer made of a transparent conductive material, substantially coating the entire surface of the device.

12. The method of any of claims 9 to 11, further comprising, after step b) and before step c), a step during which trenches (170) are filled with an insulting material (176), and a planarization step to remove the insulating material from the top surface of the diodes.

13. The method of any of claims 1 to 12, wherein said semiconductor diodes (172) are light-emitting diodes.

14. The method of claim 13, further comprising, after step b), a step of transferring, onto the surface of the device opposite to the control circuit (110), a photoluminescent conversion stack (203) with multiple quantum wells substantially coating the entire surface of the device.

15. The method of claim 14, further comprising, after the transfer of the conversion stack (203), a step of removing the conversion stack (203) opposite only some of the semiconductor diodes (172).

16. The method of any of claims 1 to 12, wherein said diodes are photodiodes.

17. The method of any of claims 1 to 16, wherein the first (153) and second (157) semiconductor layers are gallium nitride layers, said diodes (172) being gallium nitride diodes.
